# EUROPÄISCHE PATENTSCHRIFT

(11) **EP 0 467 189 B1**
(45) Veröffentlichungstag und Bekanntmachung des Hinweises auf die Patenterteilung: **08.02.1995**
(21) Anmeldenummer: 91111349.6
(22) Anmeldetag: 08.07.1991
(51) Int. Cl.: F25D 17/02, F25B 49/02, H05K 7/20

(54) **Kaltwassersatz mit Leistungsanpassung**
Cold water unit with performance adjustment
Unité d'eau froide avec ajustement de la performance

(30) Priorität: 20.07.1990 DE 4023140
(43) Veröffentlichungstag der Anmeldung: 22.01.1992
(73) Patentinhaber: Siemens Nixdorf Informationssysteme Aktiengesellschaft, 33102 Paderborn (DE)
(72) Erfinder: Sotiriu, Kornelius, Dipl.-Ing., W-8900 Augsburg (DE)
(74) Vertreter: Fuchs, Franz-Josef, Dr.-Ing.

(56) Entgegenhaltungen:
- WO-A-82/03446
- DE-A- 3 700 708
- DE-B- 1 014 134
- DE-C- 3 130 390
- FR-A- 811 014
- US-A- 1 937 984
- US-A- 3 859 812
- US-A- 4 495 777
- US-A- 4 653 287
- US-A- 4 769 998

## Beschreibung

Die Erfindung betrifft einen Kaltwassersatz mit Leistungsanpassung an die Wärmeerzeugung von Kühlobjekten, insbesondere Datenverarbeitungsanlagen bei konstanter Kaltwasservorlauftemperatur, bestehend aus einem Kälteaggregat mit wengistens einem Verdampfer, einem Kompressor, einem Kondensator und einem ein Expansionsventil enthaltenden Kühlmittelkreis, sowie einen Kaltwasserkreis der im Wärmetausch mit dem Verdampfer des Kälteaggregats steht und wenigstens einem Verbraucher, sowie einen im Kaltwasserkreis vom Kühlmittel durchflossenen Wärmetauscher, der die Differenz zwischen Kühlleistung und abzuführender Wärmeleistung durch ein Steuerelement ausgleicht, das einen Nebenschluß im Kaltwasserkreis zum Wärmetauscher herstellt und das abhängig von einer auf konstante Kaltwasservorlauftemperatur regelnden Regeleinrichtung ist.

Aus der deutschen Patentschrift 31 30 390 ist bereits ein Kaltwassersatz mit Leistunganpassung an die Wärmeerzeugung von Kühlobjekten bei konstanter Kaltwasservorlauftemperatur bekannt. Bei diesem Kaltwassersatz übersteigt die Kühlleistung des Kaltwasserkreises unter allen Betriebsbedingungen die vom Verbraucher abzuführende Wärmeleistung und er enthält im Kaltwasservorlaufkreis einen vom Kühlmittel durchflossenen Wärmetauscher der die Differenz zwischen Kühlleistung und abzuführender Wärmeleistung ausgleicht. Der Wärmetauscher liegt dabei entweder parallel oder in Reihe zum Kondensator und ist als eigenständiges Bauteil ausgeführt bei dem sowohl ein Kühlmittelkreis und ein Kaltwasserkreis vorhanden ist.

Dieser Wärmetauscher wird vom heißen Kühlmitteldampf als Wärmeträger durchströmt und erwärmt dadurch das ihn umströmende Kühlwasser des Kühlwasserkreislaufes. Die Regelung der Kühlwassertemperatur wird dadurch erreicht, daß zwischen dem Verbraucher, dem Wärmetauscher und dem Verdampfer ein Mischventil eingefügt ist, wobei durch dieses Mischventil das Kühlwasser entweder über den Wärmetauscher oder über einen Nebenschluß an den Wärmetauscher vorbeigeführt werden kann, wobei auch eine stetige Verminderung des durch den Wärmetauscher geführten Kühlwassers durch das Mischventil möglich ist. Gesteuert wird das Mischventil über eine Regeleinrichtung. Die Störgröße für die Steuerung des Mischventils wird dabei dem Kaltwasservorlauf entnommen. Die Umwälzung des Kühlwassers erfolgt über eine Pumpe. Grundsätzlich läßt sich diese Anordnung auch mit einem wassergekühlten Kondensator ausführen. In beiden Fällen sind jedoch Kondensator und Wärmetauscher selbständige baulich voneinander getrennte Einrichtungen.

Obwohl die Regelung dieses Kaltwassersatzes alle an sie gestellten Anforderungen erfüllt ist jedoch der Aufwand durch den zusätzlichen Wärmetauscher sowohl von der Platzfrage als auch von der Kostenfrage her nicht unerheblich.

Aus der DE-B1 014 134 und der WO 82/03446 sind außerdem Wärmetauscher bekannt, die die Funktion von zwei Wärmetauschern vereinigen.

In der US-A-1 937 984 wird außerdem ein geregeltes Kühlsystem und ein Verfahren beschrieben, bei dem die Übertragung vom Kühlmittelkreis auf den Nebenschluß des Kühlkreises, der zur Leistungsregelung des Kühlkreises dient, direkt im Kondensator erfolgt.

Aufgabe der vorliegenden Erfindung ist es daher, einen Kaltwassersatz, insbesondere zur Kühlung von Einrichtungen der Datentechnik zu schaffen, der bei gleicher optimaler Leistung einen vereinfachten Aufbau aufweist.

Zur Lösung dieser Aufgabe wird der Kaltwassersatz gemäß der Erfindung derart ausgebildet, daß der Kondensator zugleich der kühlmitteldurchflossene Teil des Wärmeaustauschers ist, wobei die Elemente (Lamellen, Rohre) des Kaltwasserkreises mit den Elementen des Kühlmittelkreises im Wärmetauscher untereinander abwechselnd in Strömungsrichtung der Luft vermengt sind.

Durch diese Maßnahmen erhält man den Vorteil, daß der Kältekreis vereinfacht und nur der Verdichter ein Teil mit aufwendiger Wartung ist. Diese Anordnung ermöglicht außerdem eine innige konstruktive Vermengung von Elementen (z.B. Lamellen oder Rohre) des Kühlkreises mit dem Kaltwasserkreis zur Intensivierung der Wärmekopplung.

Das Steuerelement kann entweder ein stetig veränderbares Mischventil sein oder aus zwei gegensinnig getakteten Magnetventilen bestehen.

Zur Kühlung wird dem Kondensator ein Ventilator zugeordnet.

Dieses Regelkonzept erlaubt auch im Falle eines Kühlmittelkreisschadens einen Notbetrieb wenn der Wärmetauscher als Wasserkühler umfunktioniert wird. Dazu ist notwendig, daß das gesamte Kühlwasser über den Wärmetauscher geleitet und eventuell der Ventilator auf höhere Drehzahl geschaltet wird um die Wassererwärmung in Grenzen zu halten.

Anhand der Ausführungsbeispiele nach den FIG 1 bis 3 wird die Erfindung näher erläutert: Es zeigen
- FIG 1: ein Prinzipschaltbild,
- FIG 2: ein erläuternde Ausgestaltung und
- FIG 3: eine erfindungsgemäße Ausgestaltung.

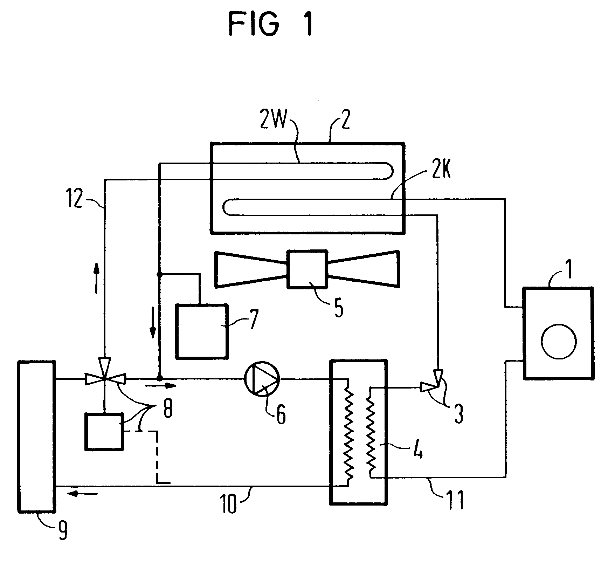

Wie in FIG 1 gezeigt, wird die im Verbraucher 9, der z.B. die Zentraleinheit eines Rechners sein kann, entstehende Wärme über den Kaltwasserkreis 10 abgeführt. Die Rückkühlung des Wassers erfolgt dabei über den Kühlmittelkreis 11. Dieser besteht aus dem Verdampfer 4, dem Kompressor 1, dem Kondensator 2K und dem Expansionsventil 3. Die Funktion eines solches Kühlkreislaufes ist die, daß Wärmemenge bei tiefer Temperatur abgenommen und bei höherer Temperatur wieder abgegeben wird. Zum Durchlaufen dieses Kreisprozesses muß von einer äußeren Quelle an diesen Kreislauf Arbeit geleistet werden. Die Wärmemenge, die bei der höheren Temperatur abgeführt wird, ist größer als das Wärmeäquivalent der in den Kreisprozeß gesteckten Arbeit. Der Verdampfer 4 besteht im einfachsten Fall aus Kühlschlangen, die beispielsweise als Rohrregister in einem Kühlraum angebracht sind. In diesen Rohren strömt eine Flüssigkeit, das sogenannte Kühlmittel, deren Siedetemperatur tiefer liegt, als die Temperatur des vom Verbraucher 9 abgeführten Wassers. Dadurch wird dem Wasser des Kaltwasserkreislaufes Wärmeenergie entzogen, durch die Rohre an das Kühlmittel übertragen, das dadurch verdampft wird. Der Dampf wird vom Kompressor 1 abgezogen, der den Druck des gasförmigen Kühlmittels soweit erhöht, daß nun die Kondensationstemperatur des Kühlmittels hoch genug ist, um im luftgekühlten Kondensator 2K zu kondensieren. Dabei wird die im verdampften Kühlmittel enthaltene Wärmeenergie an die Luft abgegeben und das nun wieder flüssige Kühlmittel über das Expansionsventil 3 dem Verdampfer 4 zugeführt, in dem ein niedriger Druck herrscht. Die Regelung der Kühlwassertemperatur wird dadurch erreicht, daß der Kaltwasserkreis einen Nebenkreis enthält, der über das Ventil 8 je nach gewünschter Temperatur mehr oder weniger zugeschaltet wird, und in dem der Wärmetauscher 2W liegt, der baulich mit dem Kondensator vereinigt ist, wobei der Kondensator 2K zugleich das kühlmitteldurchflossene Teil des Wärmetauschers 2W ist, der vom Kühlwasser durchflossen wird. Kondensator 2K und Wärmetauscher 2W sind durch diese bauliche Vereinigung 2 unmittelbar mit dem Luftstrom des Ventilators 5 thermisch eng gekoppelt. Die Störgröße für die Steuerung des Dreiwegeventils 8 wird dabei dem Kaltwasserrücklauf entnommen. Die Umnwälzung des Kühlwassers erfolgt über die Pumpe 6 zugleich ist im Regelkreis 12 ein Überlaufgefäß 7 vorgesehen, der Kondensator 2K wird durch den Ventilator 5 gekühlt.

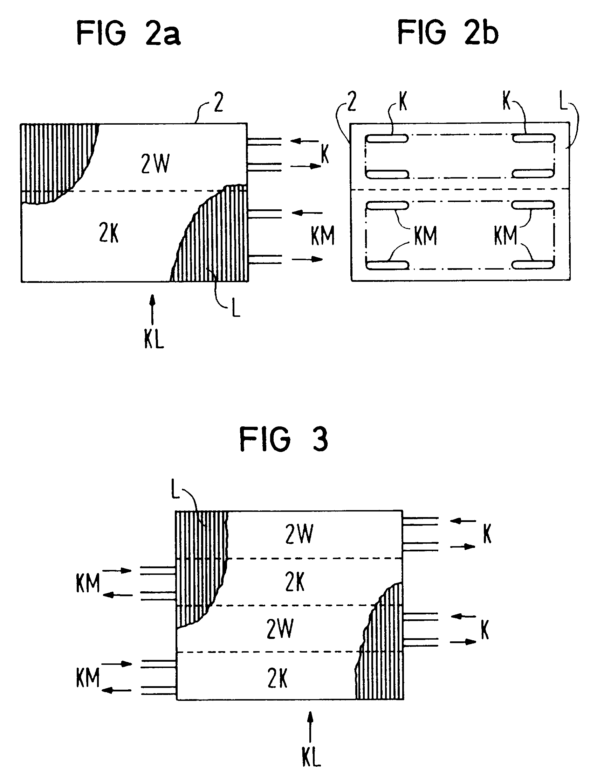

FIG 2a zeigt schematisch die Vorderansicht der Kondensatorwärmetauscherkombination 2. FIG 2b die dazugehörige Vorderansicht.

Der Wärmetauscher 2W mit den Kühlmittelleitungen K liegt oberhalb des Kondensatorteils 2K mit den Kühlmittelleitungen KM. Die Wärmekopplung erfolgt über senkrecht dazu verlaufende Lamellen L.

Eine erfindungsgemäße Ausführungsform, bei der noch eine innigere Verkopplung von Wärmetauscher und Kondensatorteil gegeben ist, zeigt FIG 3. Dort wechselt jeweils ein Wärmetauscherteil 2W mit einem Kondensatorteil 2K ab. Diese Unterteilung läßt sich beliebig oft wiederholen. Auch hier sind die Lamellen wieder die gemeinsamen Kopplungsglieder für Wärmetauscher und Kondensatorteil. Die Kühlluft KL wird über dem nicht dargestellten Ventilator von unten durch die Lamellen L geblasen.

## Patentansprüche

1. Kaltwassersatz mit Leistungsanpassung an die Wärmeerzeugung von Kühlobjekten, insbesondere Datenverarbeitungsanlagen bei konstanter Kaltwasservorlauftemperatur, bestehend aus einem Kälteaggregat mit wenigstens einem Verdampfer (4), einem Kompressor (1), einem Kondensator (2K), und einem ein Expansionsventil (3) enthaltenden Kühlmittelkreis (11), sowie einen Kaltwasserkreis (10), der im Wärmetausch mit dem Verdampfer (4) des Kälteaggregats und wenigstens einem Verbraucher (9) steht, sowie einem in den Rücklauf des Kaltwasserkreises (10) zwischen dem Verbraucher (9) und dem Verdampfe (4) geschalteten und vom Kühlmittel durchflossenen Wärmetauscher (2W), der die Differenz zwischen Kühlleistung und abzuführender Wärmeleistung durch ein Steuerelement (8) ausgleicht, das einen Nebenschluß im Kaltwasserkreis (10) zum Wärmetauscher (2W) herstellt und das abhängig von einer auf konstante Kaltwasservorlauftemperatur regelnden Regeleinrichtung ist,
**dadurch gekennzeichnet,** daß der Kondensator (2K) zugleich der kühlmitteldurchflossene Teil des Wärmetauschers ist, wobei die Elemente (Lamellen, Rohre) des Kaltwasserkreises (10) mit den Elementen des Kühlmittelkreises im Wärmetauscher (2) untereinander abwechselnd in Strömungrichtung der Luft vermengt sind.

2. Kaltwassersatz nach Anspruch 1,
**dadurch gekennzeichnet,** daß das Steuerelement (8) ein stetig veränderbares Mischventil ist.

3. Kaltwassersatz nach Anspruch 1,
**dadurch gekennzeichnet,** daß das Steuerelement (8) aus zwei gegensinnig getakteten Magnetventilen besteht.

4. Kaltwassersatz nach einem der vorhergehenden Ansprüche,
**dadurch gekennzeichnet,** daß dem Kondensator (2K) ein Ventilator (5) zur zusätzlichen Kühlung zugeordnet ist.

5. Verfahren zum Betrieb eines Kaltwassersatzes nach Anspruch 4,
**dadurch gekennzeichnet,** daß bei Ausfall des Kondensatorteils (2K) das gesamte Kühlwasser durch das Steuerelement (8) über den Wärmetauscher (2W) geleitet wird und daß die Drehzahl des Ventilators (5) für den Kondensator (2K) erhöht wird.

## Claims

1. Cold water assembly having power matching to the heat production from cooled objects, especially data processing installations having a constant cold water inlet temperature, comprising a cooling unit having at least one evaporator (4), one compressor (1), one condenser (2K) and a cooling circuit (11) containing an expansion valve (3), as well as a cold water circuit (10) which exchanges heat with the evaporator (4) of the cooling unit and at least one load (9), as well as having a heat exchanger (2W) which is connected in the cold water circuit (10) return path between the load (9) and the evaporator (4) and through which the coolant flows, and which heat exchanger (2W) compensates by means of a control element (8) for the difference between the cooling power and the heat power to be dissipated, which control element (8) produces a shunt path in the cold water circuit (10) to the heat exchanger (2W) and is dependent on a regulating device which regulates the cold water inlet to a constant temperature, characterized in that the condenser (2K) is at the same time that part of the heat exchanger through which the coolant flows, the elements (laminates, tubes) of the cold water circuit (10), together with the elements of the coolant circuit in the heat exchanger (2), being alternately mixed with one another in the flow direction of the air.

2. Cold water assembly according to Claim 1, characterized in that the control element (8) is a continuously variable mixing valve.

3. Cold water assembly according to Claim 1, characterized in that the control element (8) comprises two solenoid valves which are pulsed in opposite directions.

4. Cold water assembly according to one of the preceding claims, characterized in that a fan (5) for additional cooling is assigned to the condenser (2K).

5. Method for operation of a cold water assembly according to Claim 4, characterized in that, in the event of the condenser part (2K) failing, all the cooling water is passed via the heat exchanger (2W) by the control element (8), and in that the rotation speed of the fan (5) for the condenser (2K) is increased.

## Revendications

1. Unité d'eau froide dont la performance s'ajuste au dégagement de chaleur d'objets à refroidir, en particulier des installations de traitement de données, à température d'arrivée d'eau froide constante, consistant en une unité frigorifique ayant au moins un évaporateur (4), un compresseur (1), un condenseur (2K) et un circuit fluide de refroidissement (11) comportant une soupape de détente (3), ainsi qu'un circuit d'eau froide (10) qui se trouve en situation d'échange thermique avec l'évaporateur (4) de l'unité frigorifique et au moins un dissipateur (9), ainsi qu'un échangeur thermique (2W), placé sur le trajet de retour du circuit d'eau froide (10) entre le dissipateur (9) et l'évaporateur (4) et dans lequel passe le fluide de refroidissement, qui compense la différence entre puissance frigorifique et puissance calorifique à évacuer grâce à un élément de commande (8) qui constitue dans le circuit d'eau froide (10) un circuit en dérivation par rapport à l'échangeur thermique (2W) et qui dépend d'un dispositif de réglage réglant une température d'arrivée d'eau froide à une valeur constante,
caractérisée en ce que le condenseur (2K) est en même temps la partie de l'échangeur thermique dans laquelle passe le fluide de refroidissement, les éléments (lamelles, tubes) du circuit d'eau froide (10) étant mêlés aux éléments du circuit de fluide de refroidissement dans l'échangeur thermique (2) alternativement dans le sens de circulation de l'air.

2. Unité d'eau froide selon la revendication 1,
caractérisée en ce que l'élément de commande (8) est un régulateur à vannes constamment modifiable.

3. Unité d'eau froide selon la revendication 1,
caractérisée en ce que l'élément de commande (8) consiste en deux vannes magnétiques synchronisées en sens inverse.

4. Unité d'eau froide selon l'une des revendications précédentes,
caractérisée en ce qu'un ventilateur (5) est associé au condenseur (2K) afin de créer un refroidissement supplémentaire.

5. Procédé pour faire fonctionner une unité d'eau froide selon la revendication 4,
caractérisé en ce que, lors de la défaillance de la partie condenseur (2K), la totalité de l'eau de refroidissement est conduite, par l'élément de commande (8), à travers l'échangeur thermique (2W) et la vitesse de rotation du ventilateur (5) pour le condenseur (2K) est augmentée.
